# EUROPEAN PATENT SPECIFICATION

(11) **EP 4 568 441 B1**
(45) Date of publication and mention of the grant of the patent: **13.05.2026**
(21) Application number: 24201579.0
(22) Date of filing: 20.09.2024
(51) Int. Cl.: H10B 12/00, H10B 53/30, H10D 1/68

(54) **SEMICONDUCTOR DEVICE**
HALBLEITERANORDNUNG
DISPOSITIF SEMI-CONDUCTEUR

(30) Priority: 06.12.2023 KR 20230175435
(43) Date of publication of application: 11.06.2025
(73) Proprietor: Samsung Electronics Co., Ltd., Gyeonggi-do, 16677 (KR)
(72) Inventor: KIM, Suhwan, 16677 Suwon-si (KR); KU, Myeong-chan, 16677 Suwon-si (KR); SHIN, Dongmin, 16677 Suwon-si (KR); WOO, Kayeon, 16677 Suwon-si (KR); KIM, Beom-Jong, 16677 Suwon-si (KR); CHUNG, Sukjin, 16677 Suwon-si (KR); JUNG, Hyungsuk, 16677 Suwon-si (KR)
(74) Representative: Marks & Clerk LLP

(56) References cited:
- US-A1- 2022 344 359
- US-A1- 2023 290 810

## Description

### BACKGROUND

Semiconductor devices have an important role in the electronic industry because of their small size, multi-functionality, and/or low fabrication cost. Semiconductor devices may be categorized as any one of semiconductor memory devices storing logic data, semiconductor logic devices processing operations of logic data, and hybrid semiconductor devices having both memory and logic elements.

As the semiconductor devices are developed to high integration, capacitors are required to have high capacitance in a limited area. The capacitance of the capacitor is proportional to a surface of an electrode and a dielectric constant of a dielectric layer while being inversely proportional to an equivalent oxide thickness of the dielectric layer.

Document US2023290810 A1 discloses a semiconductor device comprising a capacitor, the capacitor comprising ferroelectric and antiferroelectric layers.

### SUMMARY

The present disclosure relates to a semiconductor device, and more particularly, to a semiconductor device including a capacitor.

Some implementations provide a semiconductor device with increased capacitance.

Some implementations provide a semiconductor device having reduced leakage current.

The object of the present disclosure is not limited to the above-mentioned elements, and other objects which have not been mentioned above will be clearly understood to those skilled in the art from the following description.

A semiconductor device may comprise a capacitor. The capacitor may include: a bottom electrode; a first sub-dielectric layer on the bottom electrode; a second sub-dielectric layer on the first sub-dielectric layer; and a top electrode on the second sub-dielectric layer. The second sub-dielectric layer may include: a first antiferroelectric layer on the first sub-dielectric layer; a second antiferroelectric layer on the first antiferroelectric layer; and a first ferroelectric layer between the first antiferroelectric layer and the second antiferroelectric layer. Each of the first and second antiferroelectric layers may include zirconium oxide that is doped with a first element. The first sub-dielectric layer may include zirconium oxide that is not doped with the first element.

A semiconductor device may comprise: a substrate; a plurality of word lines in the substrate; a first impurity region in the substrate on one side of the word lines; a second impurity region in the substrate between the word lines; a bit line connected to the second impurity region and on the substrate, the bit line perpendicular to the word lines; a conductive contact connected to the first impurity region and on the substrate; a bottom electrode on the conductive contact; a dielectric layer on the bottom electrode; a top electrode on the dielectric layer; and a support pattern in contact with an upper lateral surface of the bottom electrode. The dielectric layer may include a first sub-dielectric layer and a second sub-dielectric layer that are sequentially stacked. The second sub-dielectric layer may include: a plurality of antiferroelectric layers on the first sub-dielectric layer; and a plurality of ferroelectric layers correspondingly between the antiferroelectric layers. Each of the antiferroelectric layers may include zirconium oxide that is doped with a first element. The first sub-dielectric layer may include zirconium oxide that is not doped with the first element. A sum of thicknesses of the ferroelectric layers may be about 0.2 times to about 0.4 times a thickness of the dielectric layer.

A semiconductor device may comprise: a substrate; a plurality of conductive contacts on the substrate; and a plurality of capacitors on the conductive contacts. Each of the capacitors may include: a bottom electrode; a dielectric layer on the bottom electrode; and a top electrode on the dielectric layer. The dielectric layer may include a first sub-dielectric layer and a second sub-dielectric layer that are sequentially stacked. The second sub-dielectric layer may include: a first antiferroelectric layer on the first sub-dielectric layer; a second antiferroelectric layer on the first antiferroelectric layer; and a first ferroelectric layer between the first antiferroelectric layer and the second antiferroelectric layer. The first sub-dielectric layer may have a first thickness. The first ferroelectric layer may have a second thickness. Each of the first and second antiferroelectric layers may have a third thickness. Each of the first, second, and third thicknesses may be in a range of about 5 Å to about 15 Å (e.g. of 5 Å to 15 Å).

At least some of the above and other features of the invention are set out in the claims.

### BRIEF DESCRIPTION OF DRAWINGS

FIG. 1 illustrates a cross-sectional view showing an example semiconductor device.
FIG. 2 illustrates a plan view showing an example semiconductor device.
FIG. 3 illustrates a cross-sectional view taken along line A-A' of FIG. 2.
FIG. 4A illustrates an enlarged view showing section P1 of FIG. 3.
FIG. 4B illustrates a plan view showing an example semiconductor device taken along line E-E' of FIG. 3.
FIGS. 5A, 5B, 5D, 5E, 5F, and 5G illustrate diagrams showing an example method of fabricating a semiconductor device having a cross-section of FIG. 3.
FIG. 5C illustrates a plan view showing an example method of fabricating a semiconductor device having a cross-section of FIG. 2.
FIG. 6 illustrates a cross-sectional view taken along line A-A' of FIG. 2.
FIG. 7 illustrates a cross-sectional view taken along line A-A' of FIG. 2.
FIG. 8 illustrates a cross-sectional view showing an example semiconductor device.
FIG. 9 illustrates a cross-sectional view showing an example semiconductor device.
FIG. 10 illustrates an enlarged view showing section P2 of FIGS. 6, 7, 8, and 9.
FIG. 11 illustrates a plan view showing an example semiconductor device.
FIG. 12 illustrates a cross-sectional view taken along lines C-C' and D-D' of FIG. 11.
FIG. 13 illustrates a perspective view showing an example three-dimensional semiconductor memory device.
FIG. 14 illustrates a cross-sectional view taken along line F-F' of FIG. 13.

### DETAILED DESCRIPTION

Some implementations will now be described in detail with reference to the accompanying drawings.

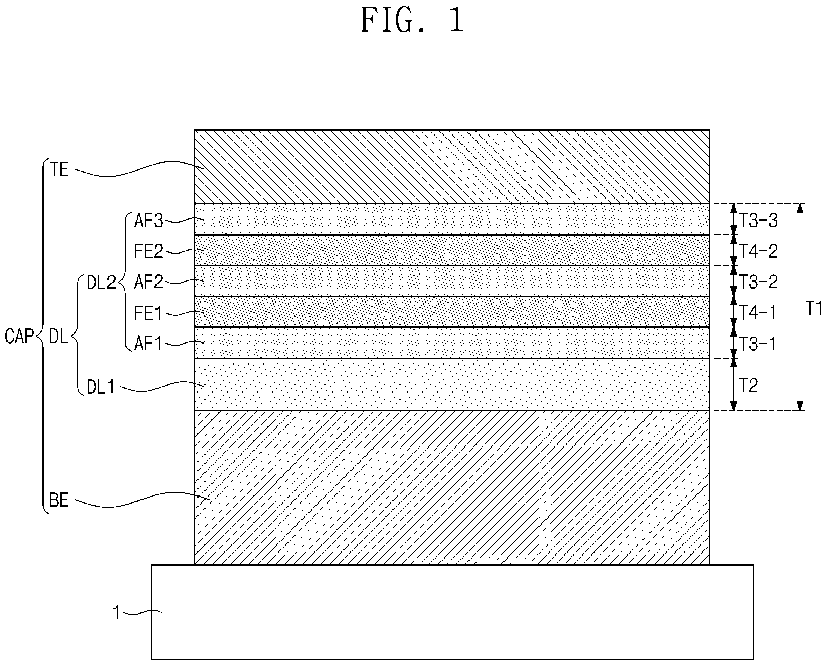

FIG. 1 illustrates a cross-sectional view showing an example semiconductor device.

Referring to FIG. 1, a lower layer 1 may be provided. The lower layer 1 may be a semiconductor layer, a dielectric layer, or a conductive layer. The lower layer 1 may include a semiconductor substrate, an interlayer dielectric layer, and a contact plug. A capacitor CAP may be provided on the lower layer 1. For example, the capacitor CAP may serve as a data storage element for allowing a semiconductor device to act as a memory device. The capacitor CAP may include a bottom electrode BE, a dielectric layer DL, and a top electrode TE that are sequentially stacked.

The dielectric layer DL may be disposed on the bottom electrode BE. The dielectric layer DL may include a first sub-dielectric layer DL1 and a second sub-dielectric layer DL2. The first sub-dielectric layer DL1 may be in contact with the bottom electrode BE. The device, however, is not limited thereto, and an additional material layer may further be disposed between the first sub-dielectric layer DL1 and the bottom electrode BE. The second sub-dielectric layer DL2 may be disposed on the first sub-dielectric layer DL1. The second sub-dielectric layer DL2 may be in contact with the top electrode TE. The device, however, is not limited thereto, and an additional material layer may further be disposed between the second sub-dielectric layer DL2 and the top electrode TE.

The second sub-dielectric layer DL2 may include at least one antiferroelectric material layer and at least one ferroelectric material layer. For example, as shown in FIG. 1, the second sub-dielectric layer DL2 may include a first antiferroelectric layer AF1, a second antiferroelectric layer AF2, and a third antiferroelectric layer AF3 that are sequentially stacked. The first, second, and third antiferroelectric layers AF1, AF2, and AF3 may be spaced apart from each other. The first antiferroelectric layer AF1 may be in contact with the first sub-dielectric layer DL1. A first ferroelectric layer FE1 may be interposed between the first and second antiferroelectric layers AF1 and AF2, and a second ferroelectric layer FE2 may be interposed between the second and third antiferroelectric layers AF2 and AF3. The first and second ferroelectric layers FE1 and FE2 may be spaced apart from each other. The third antiferroelectric layer AF3 may be in contact with the top electrode TE. The device, however, is not limited thereto, and an additional material layer may further be disposed between the third antiferroelectric layer AF3 and the top electrode TE. According to some implementations, different from that shown in FIG. 1, the first ferroelectric layer FE1 may be disposed between the first sub-dielectric layer DL1 and the first antiferroelectric layer AF1.

The first sub-dielectric layer DL1 may include an antiferroelectric material. The antiferroelectric material may include, for example, at least one selected from ZrO₂, HfₓZr₁₋ₓO₂, PbZrO₃, and AgNbO₃, where x is less than 0.5. For example, the first sub-dielectric layer DL1 may include zirconium oxide. The present devices, however, are not limited to the materials discussed above.

Each of the first, second, and third antiferroelectric layers AF1, AF2, and AF3 may include the antiferroelectric material. At least one of the first, second, and third antiferroelectric layers AF1, AF2, and AF3 may include an antiferroelectric material doped with a first element. For example, at least one of the first, second, and third antiferroelectric layers AF1, AF2, and AF3 may include zirconium oxide doped with the first element. The first element may include, for example, at least one selected from Al, Mg, Be, Y, La, Ca, C, Si, Ge, Sn, Pb, Gd, and Ti.

In the present implementation, the first element may not be doped into the first sub-dielectric layer DL1. As the first sub-dielectric layer DL1 in contact with the bottom electrode BE includes the antiferroelectric material that is not doped with the first element, there may be an increase in crystallinity of the second sub-dielectric layer DL2 stacked on the first sub-dielectric layer DL1.

Each of the first and second ferroelectric layers FE1 and FE2 may include a ferroelectric material. The ferroelectric material may include, for example, at least one selected from HfO₂, Hf_{y}Zr_{1-y}O₂, BaTiO₃, SrTiO₃, and Sr_{y}Ba_{1-y}TiO₃, where y is equal to or greater than 0.5. For example, each of the first and second ferroelectric layers FE1 and FE2 may include hafnium oxide or hafnium-zirconium oxide. Each of the first and second ferroelectric layers FE1 and FE2 may not include the first element. The present devices, however, are not limited to the material discussed above.

A ratio of 10:0 to 5:5 may be given as a component ratio of hafnium included in each of the first and second ferroelectric layers FE1 and FE2 to zirconium included in each of the first and second ferroelectric layers FE1 and FE2. For example, ZrₓHf₁₋ₓO₂ may be used with 0 ≤ x ≤ 0.5 for the zirconium-hafnium oxide in each of the first and second ferroelectric layers FE1 and FE2. The hafnium oxide may have ferroelectricity, and the zirconium oxide may have antiferroelectricity. As a portion of the hafnium oxide is greater than that of the zirconium oxide in the first and second ferroelectric layers FE1 and FE2, each of the first and second ferroelectric layers FE1 and FE2 may exhibit ferroelectricity.

There may be a difference in crystal phase distribution between the first, second, and third antiferroelectric layers AF1, AF2, and AF3 and the first and second ferroelectric layers FE1 and FE2. For example, each of the first, second, and third antiferroelectric layers AF1, AF2, and AF3 may include (e.g. may have) a tetragonal crystal phase having antiferroelectricity. Each of the first and second ferroelectric layers FE1 and FE2 may include (e.g. may have) an orthorhombic crystal phase having ferroelectricity. The present device, however, is not limited thereto, and the first, second, and third antiferroelectric layers AF1, AF2, and AF3 and the first and second ferroelectric layers FE1 and FE2 may independently include (e.g. may have or may contain) both a tetragonal crystal phase and an orthorhombic crystal phase.

The first, second, and third antiferroelectric layers AF1, AF2, and AF3 may include (e.g. may have or may contain) a tetragonal crystal phase more than an orthorhombic crystal phase, and the first and second ferroelectric layers FE1 and FE2 may include (e.g. may have or may contain) an orthorhombic crystal phase more than a tetragonal crystal phase. The crystal phase distribution may be confirmed by using, for example, transmission electron microscopy (TEM), grazing incidence X-ray diffraction (GIXRD), energy dispersive X-ray spectroscopy (EDX), electron energy loss spectroscopy (EELS), or secondary ion mass spectroscopy (SIMS).

As the first, second, and third antiferroelectric layers AF1, AF2, and AF3 include the antiferroelectric material doped with the first element, crystallization may be induced on the first ferroelectric layer FE1 interposed between the first and second antiferroelectric layers AF1 and AF2 and induced on the second ferroelectric layer FE2 interposed between the second and third antiferroelectric layers AF2 and AF3. An application of voltage may cause the first, second, and third antiferroelectric layers AF1, AF2, and AF3 to easily transform from a tetragonal crystal phase to an orthorhombic crystal phase. Therefore, within a driving voltage range (e.g., between -1.0 V and 1.0 V) or within a lower voltage range (e.g., between -0.9 V and 0.9 V), there may be formed a morphotropic phase boundary (MPB) in which a tetragonal crystal phase and an orthorhombic crystal phase coexist between the antiferroelectric layers AF1, AF2, and AF3 and the ferroelectric layers FE1 and FE2, and there may be an improvement in piezoelectric properties of the capacitor CAP. Accordingly, a semiconductor device may increase in capacitance and decrease in leakage current.

For example, the dielectric layer DL may have a first thickness T1 of about 20 Å to about 60 Å (e.g. of 20 Å to 60 Å). The first sub-dielectric layer DL1 may have a second thickness T2 of about 5 Å to about 15 Å (e.g. of 5 Å to 15 Å). Each of the first, second, and third antiferroelectric layers AF1, AF2, and AF3 may have a third thickness T3 of about 5 Å to about 15 Å (e.g. of 5 Å to 15 Å). The third thicknesses T3-1, T3-2, and T3-3 of the first, second, and third antiferroelectric layers AF1, AF2, and AF3 may be the same (collectively T3) as or different from each other. Each of the first and second ferroelectric layers FE1 and FE2 may have a fourth thickness T4-1 and T4-2 of about 5 Å to about 15 Å (e.g. of 5 Å to 15 Å). The fourth thicknesses T4 of the first and second ferroelectric layers FE1 and FE2 may be the same (collectively T4) as or different from each other. A sum of the fourth thicknesses T4 of the first and second ferroelectric layers FE1 and FE2 may be about 0.2 times to about 0.4 times (e.g. 0.2 times to 0.4 times) the first thickness T1 of the dielectric layer DL. For example, a ratio of the summed thickness of the first and second ferroelectric layers FE1 and FE2 to the thickness of the dielectric layer DL may range from about 20% to about 40% (e.g. 20% to 40%). A capacitance of the capacitor CAP may be adjusted by adjusting the thicknesses of the antiferroelectric layers AF1, AF2, and AF3 and the ferroelectric layers FE1 and FE2 in the dielectric layer DL so as to form the morphotropic phase boundary (MPB) in the dielectric layer DL.

Each of the bottom electrode BE and the top electrode TE may include a conductive material, such as impurity-doped silicon, impurity-doped silicon germanium, metal, metal nitride, conductive oxide, and metal silicide. For example, each of the bottom electrode BE and the top electrode TE may include at least one selected from VN, TiN, NbN, MoN, TaN, Ru, RuO₂, Pt, Ir, SrRuO₃, W, and WN. Each of the bottom electrode BE and the top electrode TE may be a single layer formed of one material or a multiple layer formed of two or more materials.

The following will describe a method of fabricating the capacitor CAP depicted in FIG. 1.

Referring to FIG. 1, a bottom electrode BE may be formed on a lower layer 1. The bottom electrode BE may undergo deposition processes such as atomic layer deposition (ALD) to sequentially deposit a first sub-dielectric layer DL1, a first antiferroelectric layer AF1, a first ferroelectric layer FE1, a second antiferroelectric layer AF2, a second ferroelectric layer FE2, and a third antiferroelectric layer AF3, thereby forming a dielectric layer DL. A top electrode TE may be formed on the dielectric layer DL to fabricate a semiconductor device having a cross-section of FIG. 1.

When the first, second, and third antiferroelectric layers AF1, AF2, and AF3 are deposited, an absorption controlled atomic layer deposition (ACALD) process and a lamination process may be employed to dope a first element into each of the first, second, and third antiferroelectric layers AF1, AF2, and AF3. For example, when the first antiferroelectric layer AF1 is formed, one atomic layer of zirconium (Zr) may be deposited by feeding a zirconium (Zr) precursor onto a surface of the first sub-dielectric layer DL1. An inert gas (e.g., Ar) may be used to purge a zirconium (Zr) precursor that is not adsorbed. After purging, atoms of the first element to be doped may be adsorbed to a surface of the atomic layer of Zr, and an inert gas (e.g., Ar) may be used again to remove non-adsorbed atoms of the first element. An oxygen-containing gas (e.g., O₂ or O₃) may be supplied to combine oxygen with the surface of the atomic layer of Zr doped with the first element. The process cycle may be repeated several times to form the first antiferroelectric layer AF1 having a desired thickness T3.

The degree of distribution and concentration of the first element doped into the first antiferroelectric layer AF1 may be adjusted as much as desired by controlling the number of adsorbing atoms of the first element, a time length of adsorption of atoms of the first element, and the number of repetitions of the ALD cycle. The formation of the second and third antiferroelectric layers AF2 and AF3 may follow the same process as for the formation of the first antiferroelectric layer AF1.

The formation of the first and second ferroelectric layers FE1 and FE2 may include depositing hafnium oxide and depositing zirconium oxide. The formation of the first and second ferroelectric layers FE1 and FE2 may not include the procedure of doping the first element. When the first and second ferroelectric layers FE1 and FE2 are formed, deposition thicknesses of hafnium oxide and zirconium oxide may be adjusted to control a component ratio of hafnium oxide and zirconium oxide in each of the first and second ferroelectric layers FE1 and FE2.

The capacitor CAP may have various shapes. A detailed description thereof will be given below.

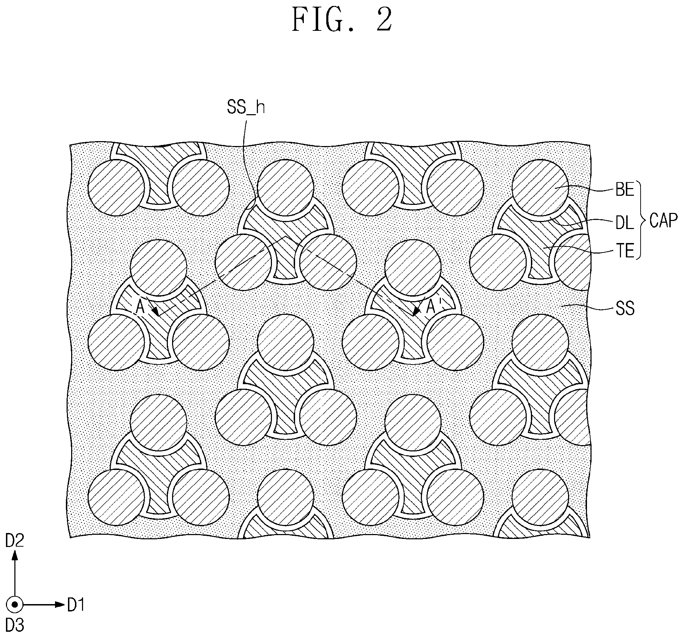

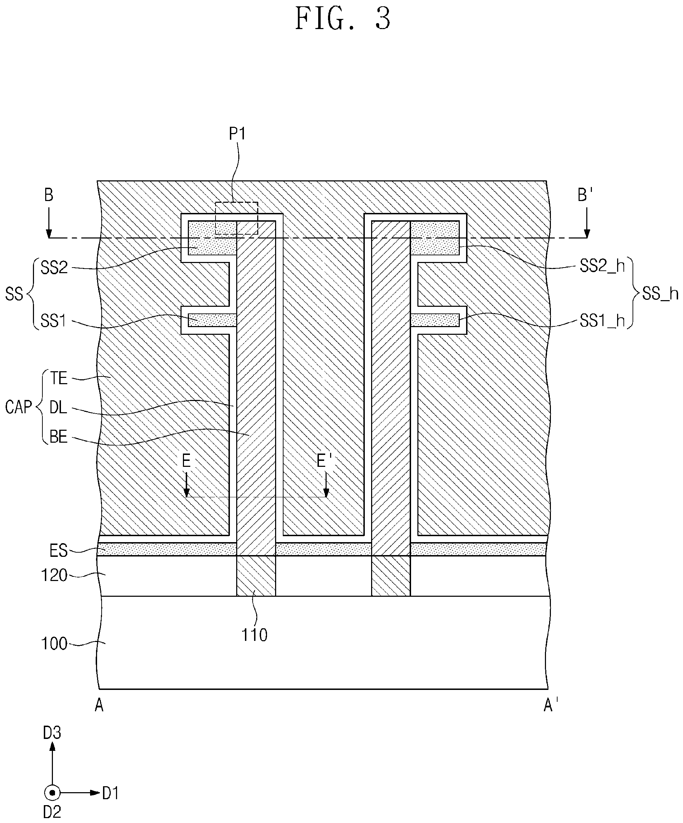

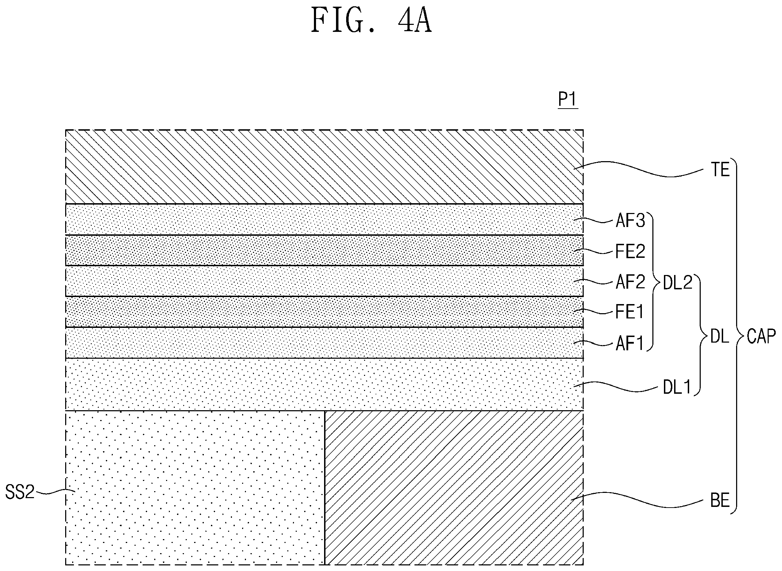

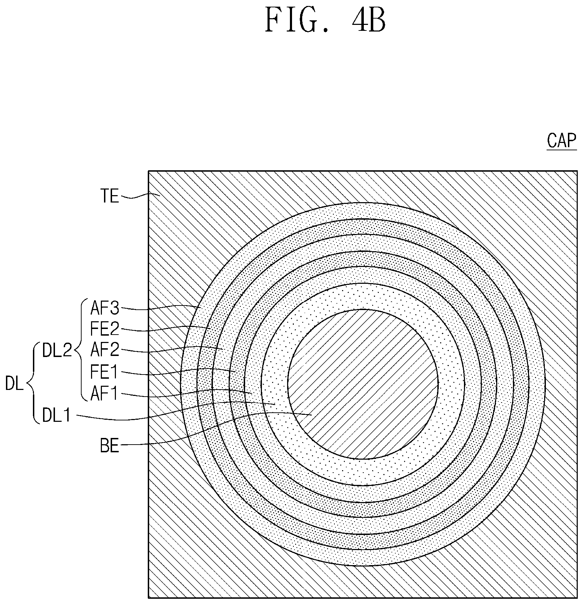

FIG. 2 illustrates a plan view showing an example semiconductor device. FIG. 3 illustrates a cross-sectional view taken along line A-A' of FIG. 2. FIG. 4A illustrates an enlarged view showing section P1 of FIG. 3. FIG. 2 may correspond to a plan view taken along line B-B' of a semiconductor device depicted in FIG. 3. FIG. 4B illustrates a plan view showing an example semiconductor device taken along line E-E' of FIG. 3.

Referring to FIGS. 2 and 3, a first substrate 100 may be provided. The first substrate 100 may be a semiconductor substrate. The first substrate 100 may be, for example, a silicon substrate, a germanium substrate, or a silicon-germanium substrate. An interlayer dielectric layer 120 may be disposed on the first substrate 100. The interlayer dielectric layer 120 may include, for example, at least one selected from silicon nitride, silicon oxide, and silicon oxynitride. Conductive contacts 110 may be disposed in the interlayer dielectric layer 120. The conductive contacts 110 may penetrate the interlayer dielectric layer 120 to come into electrical connection with the first substrate 100. The conductive contacts 110 may include at least one selected from an impurity-doped polysilicon pattern, a titanium nitride layer, and a tungsten layer.

Although not shown, the first substrate 100 may be provided therein with a device isolation layer that defines active sections. Word lines may be buried in the first substrate 100. The word lines may be insulated through a gate dielectric layer and a capping pattern from the first substrate 100. Source/drain regions may be provided to include impurity regions disposed in the first substrate 100 on opposite sides of each of the word lines. The impurity regions on one side of the word lines may be electrically connected to corresponding bit lines. The conductive contacts 110 may be electrically connected to the impurity regions on another side of each of the word lines.

An etch stop layer ES may be disposed on the interlayer dielectric layer 120. The etch stop layer ES may cover the interlayer dielectric layer 120 and expose the conductive contacts 110. The etch stop layer ES may be formed of, for example, a single or multiple layers including at least one selected from a silicon nitride layer, a silicon boronitride (SiBN) layer, and a silicon carbonitride (SiCN) layer.

A capacitor CAP may correspond to the capacitor CAP of FIG. 1. The capacitor CAP may include a bottom electrode BE, a dielectric layer DL, and a top electrode TE.

The bottom electrodes BE may penetrate the etch stop layer ES to come into contact with corresponding conductive contacts 110. As shown in FIG. 2, the bottom electrodes BE may each have a plug shape (e.g. cylindrical shape) having a circular cross-section. The bottom electrodes BE may be arranged in a honeycomb shape (e.g. honeycomb pattern) when viewed in plan. In an example, six bottom electrodes BE may be disposed to constitute a hexagonal shape around one bottom electrode BE. As shown in FIG. 3, the bottom electrodes BE may each have a pillar shape. The bottom electrodes BE may include at least one selected from impurity-doped polysilicon, metal, metal oxide, and metal nitride. For example, the bottom electrodes BE may include a titanium nitride layer.

A support pattern SS may be provided on the first substrate 100. The support pattern SS may be provided between neighboring bottom electrodes BE. The support pattern SS may be provided in plural. For example, the support pattern SS may include a first support pattern SS1 and a second support pattern SS2.

The bottom electrodes BE may have their lateral surfaces (e.g. side surfaces) in contact with the first support pattern SS1 and the second support pattern SS2. The first support pattern SS1 and the second support pattern SS2 may be spaced apart from each other. The second support pattern SS2 may be positioned above the first support pattern SS1. The second support pattern SS2 may have a top surface located at a level the same as or different from that of top surfaces of the bottom electrodes BE. One or both of the first support pattern SS1 and the second support pattern SS2 may be formed of a single layer or multiple layers including, for example, at least one selected from a silicon nitride (SiN) layer, a silicon boronitride (SiBN) layer, and a silicon carbonitride (SiCN) layer.

The first support pattern SS1 and the second support pattern SS2 may have different thicknesses from each other. For example, the thickness of the second support pattern SS2 may be greater than that of the first support pattern SS1. The first and second support patterns SS1 and SS2 may include their own support holes SS_h. The first support pattern SS1 may have first support holes SS1_h. The second support pattern SS2 may have second support holes SS2_h. The first support holes SS1_h may vertically overlap the second support holes SS2_h. The support holes SS_h may each expose sidewalls of three bottom electrodes BE that are adjacent to each other.

The first support pattern SS1, the second support pattern SS2, the etch stop layer ES, and the bottom electrodes BE may have their surfaces that are conformally covered with the dielectric layer DL. The dielectric layer DL may include, for example, a silicon oxide layer or a metal oxide layer whose dielectric constant is greater than that of a silicon oxide layer. For example, the dielectric layer DL may be formed of a single layer or of multiple layers including at least one selected from a hafnium oxide layer, an aluminum oxide layer, and a zirconium oxide layer.

The top electrode TE may be positioned on the dielectric layer DL. The top electrode TE may cover the bottom electrodes BE and the first and second support patterns SS1 and SS2. The top electrode layer TE may be formed of a single layer or of multiple layers including at least one selected from a titanium nitride layer, an impurity-doped polysilicon layer, and an impurity-doped silicon-germanium layer.

Referring to FIG. 4A, the dielectric layer DL may include a first sub-dielectric layer DL1 and a second sub-dielectric layer DL2. The second sub-dielectric layer DL2 may include a first antiferroelectric layer AF1, a second antiferroelectric layer AF2, a third antiferroelectric layer AF3, a first ferroelectric layer FE1, and a second ferroelectric layer FE2. The dielectric layer DL may correspond to the dielectric layer DL of FIG. 1.

For example, as shown in FIG. 4A, the first sub-dielectric layer DL1, the first, second, and third antiferroelectric layers AF1, AF2, and AF3, and the first and second ferroelectric layers FE1 and FE2 may be interposed between the bottom electrode BE and the top electrode TE. The first sub-dielectric layer DL1 may cover the bottom electrode BE and the second support pattern SS2.

Referring to FIG. 4B, the bottom electrode BE may have a circular shape when viewed in plan. Alternatively, when viewed in plan, the bottom electrode BE may include a seam therein or may have a hollow donut shape (e.g. a ring or annular shape). When a donut-shaped bottom electrode BE is provided, the top electrode TE may further be provided within the bottom electrode BE, and the dielectric layer DL may be interposed between the bottom electrode BE and the top electrode TE.

The first sub-dielectric layer DL1 and the second sub-dielectric layer DL2 may sequentially surround the bottom electrode BE. For example, the bottom electrode BE may be conformally surrounded by the first sub-dielectric layer DL1, the first antiferroelectric layer AF1, the first ferroelectric layer FE1, the second antiferroelectric layer AF2, the second ferroelectric layer FE2, and the third antiferroelectric layer AF3. The top electrode TE may surround the third antiferroelectric layer AF3. The first sub-dielectric layer DL1, the first, second, and third antiferroelectric layers AF1, AF2, and AF3, and the first and second ferroelectric layers FE1 and FE2 may be the same as or similar to those discussed in FIG. 1.

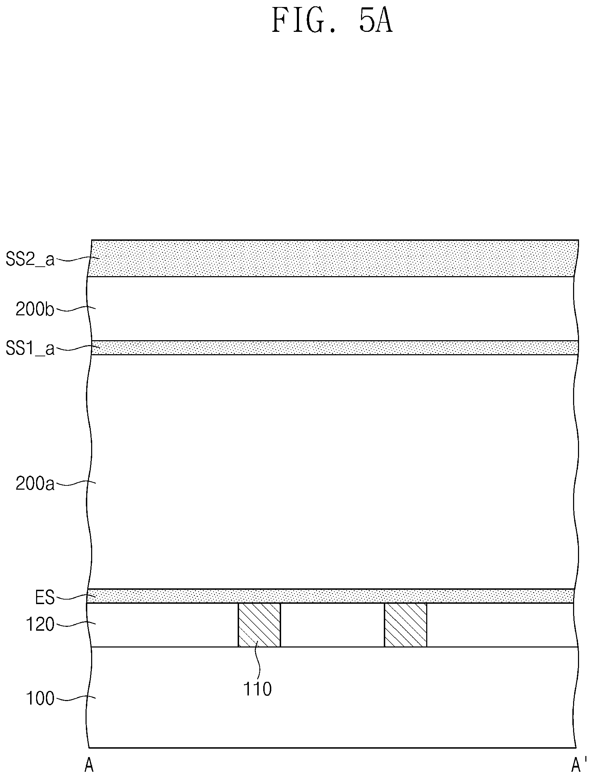

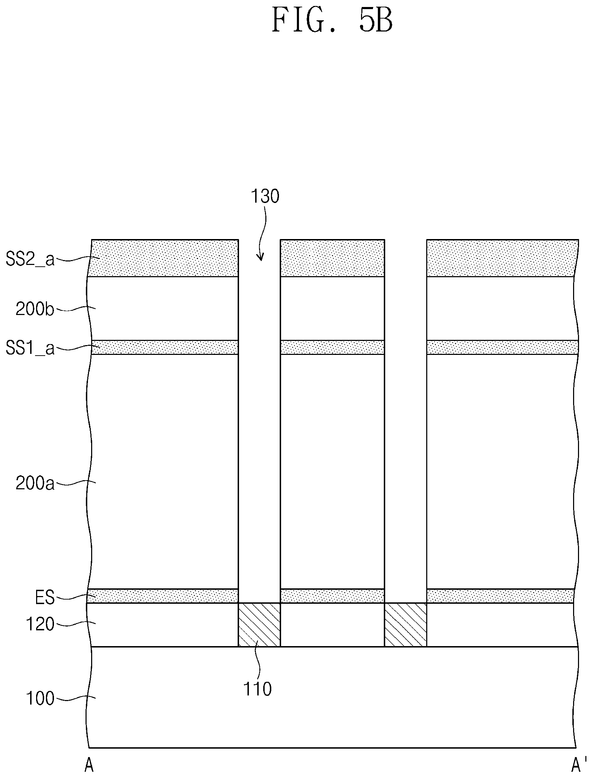

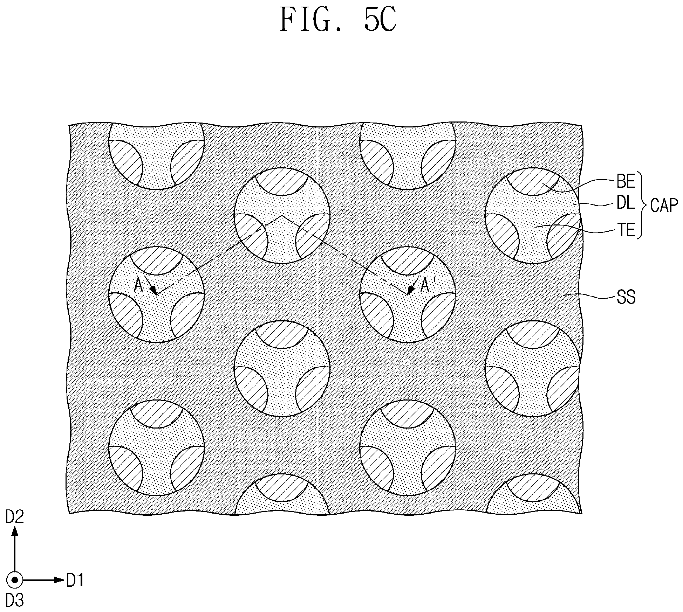

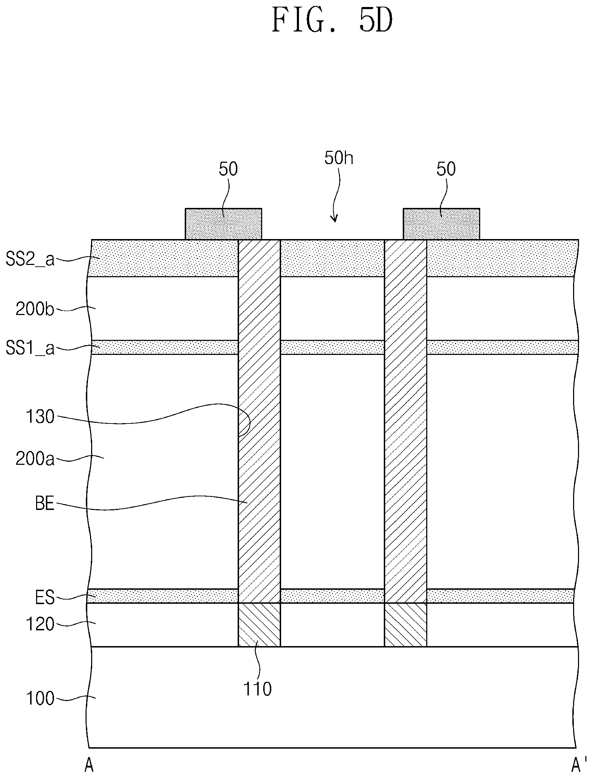

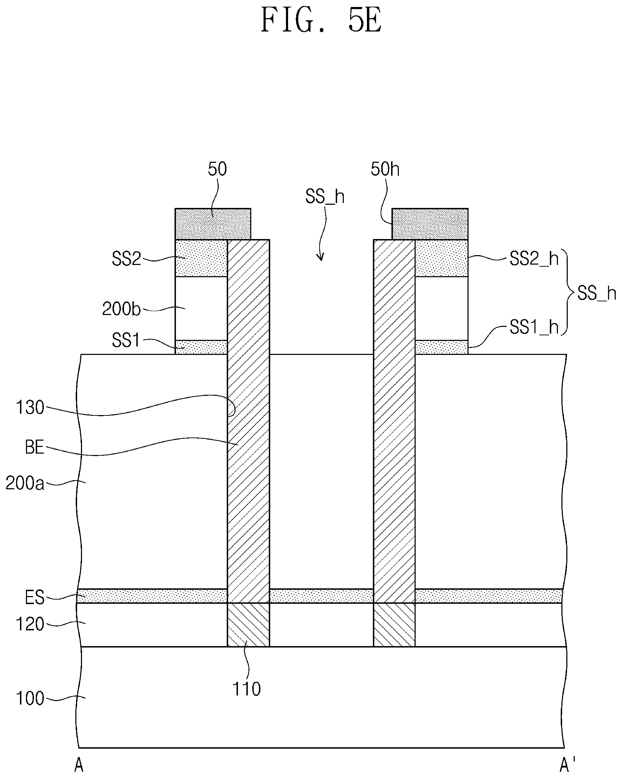

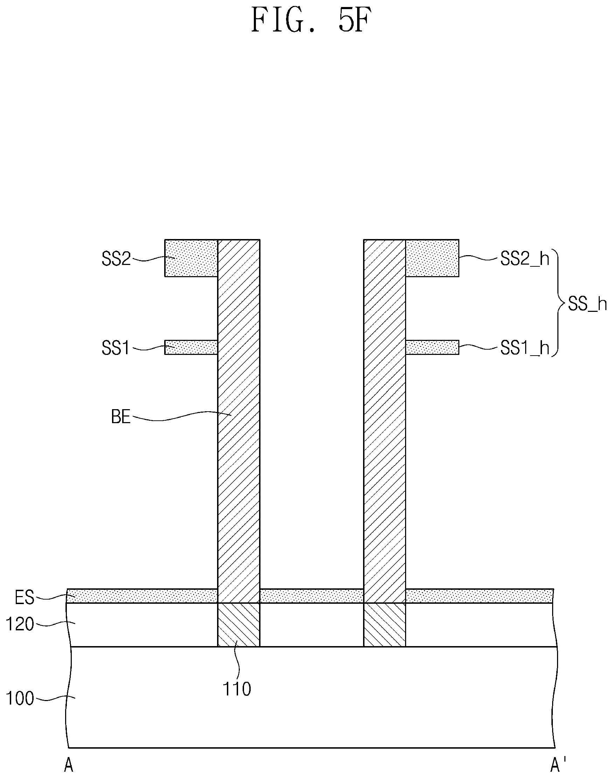

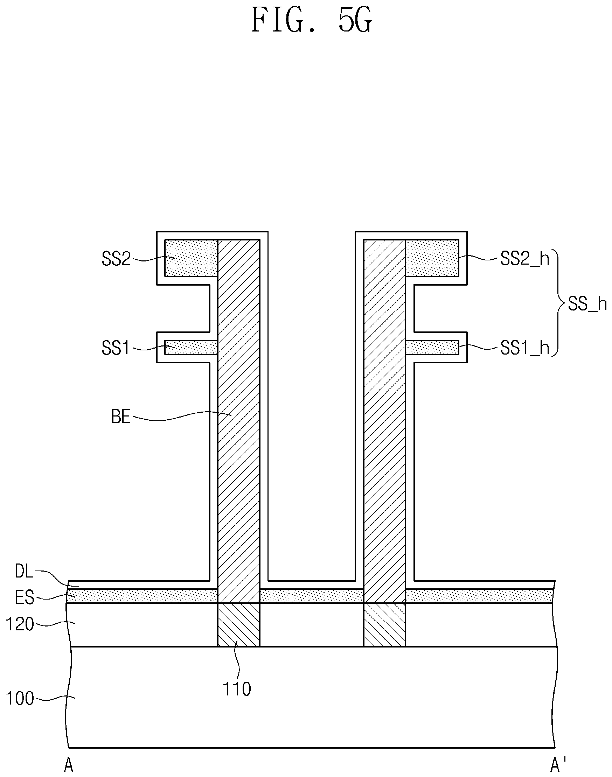

FIGS. 5A, 5B, 5D, 5E, 5F, and 5G illustrate diagrams showing an example method of fabricating a semiconductor device having a cross-section of FIG. 3. FIG. 5C illustrates a plan view showing an example method of fabricating a semiconductor device having a cross-section of FIG. 2. FIG. 5D may correspond to a cross-sectional view taken along line A-A' of FIG. 5C.

Referring to FIG. 5A, an interlayer dielectric layer 120 may be formed on a first substrate 100. Conductive contacts 110 may be formed in the interlayer dielectric layer 120. An etch stop layer ES may be formed on the interlayer dielectric layer 120 and the conductive contacts 110. A first mold layer 200a, a first support layer SS1_a, a second mold layer 200b, and a second support layer SS2_a may be sequentially stacked on the etch stop layer ES.

The first support layer SS1_a and the second support layer SS2_a may be formed of the same material. The first mold layer 200a and the second mold layer 200b may include the same material having an etch selectivity with respect to the first support layer SS1_a and to the second support layer SS2_a. For example, the first mold layer 200a and the second mold layer 200b may be formed of a silicon oxide layer. The first support layer SS1_a and the second support layer SS2_a may be formed of a single layer or of multiple layers including at least one selected from a silicon nitride (SiN) layer, a silicon boronitride (SiBN) layer, and a silicon carbonitride (SiCN) layer. The first mold layer 200a may be formed thicker than the second mold layer 200b. The second support layer SS2_a may be formed thicker than the first support layer SS1_a.

Referring to FIG. 5B, the second support layer SS2_a, the second mold layer 200b, the first support layer SS1_a, the first mold layer 200a, and the etch stop layer ES may be sequentially etched to form lower electrode holes 130 that correspondingly expose the conductive contacts 110.

Referring to FIGS. 5C and 5D, a conductive layer may be stacked on a front surface of the first substrate 100 to fill the lower electrode holes 130 and may be etched to form bottom electrodes BE in corresponding lower electrode holes 130. A top surface of the second support layer SS2_a may be exposed. A mask pattern 50 may be formed on the second support layer SS2_a. The mask pattern 50 may include openings 50h that partially expose the top surfaces of the bottom electrodes BE. For example, the openings 50h may each partially expose the top surfaces of three neighboring bottom electrodes BE and the top surface of the second support layer SS2_a between the three neighboring bottom electrodes BE.

Referring to FIG. 5E, the mask pattern 50 may be used as an etching mask to perform an anisotropic etching process to sequentially pattern the second support layer SS2_a exposed by the openings 50h, the second mold layer 200b below the second support layer SS2_a, and the first support layer SS1_a below the second support layer SS2_a, thereby forming support holes SS_h that expose a top surface of the first mold layer 200a. In this step, the first support layer SS1_a may be etched to form a first support pattern SS1 that has first support holes SS1_h. In addition, the second support layer SS2_a may be etched to form a second support pattern SS2 that has second support holes SS2_h. The first support holes SS1_h may vertically overlap corresponding second support holes SS2_h, and may have their shape and size the same as or similar to that of the first support holes SS1_h. Moreover, a sidewall of the second mold layer 200b may also be exposed.

Referring to FIG. 5F, an isotropic etching process may be performed to remove the second mold layer 200b and the first mold layer 200a exposed by the support holes SS_h, thereby exposing surfaces of the bottom electrodes BE. The isotropic etching process may expose a top surface of the etch stop layer ES and top, lateral, and bottom surfaces of the first and second support patterns SS1 and SS2.

Alternatively, an anisotropic etching process may be employed to etch the second support layer SS2_a to form the second support pattern SS2 including the second support hole SS2_h, and then an isotropic etching process may be employed to remove the second mold layer 200b through the second support hole SS2_h. Afterwards, an anisotropic etching process may be employed to etch the first support layer SS1_a to form the first support pattern SS1 including the first support hole SS1_h, and an isotropic etching process may be employed to remove the first mold layer 200a through the first support hole SS1_h.

Referring to FIGS. 4A, 4B, and 5G, an atomic layer deposition (ALD) process may be performed to deposit a dielectric layer DL on the bottom electrodes BE, the etch stop layer ES, and the first and second support patterns SS1 and SS2. The formation of the dielectric layer DL may be the same as that discussed with reference to FIG. 1. A top electrode TE may be formed on the dielectric layer DL to fabricate a semiconductor device having a cross-section of FIG. 3.

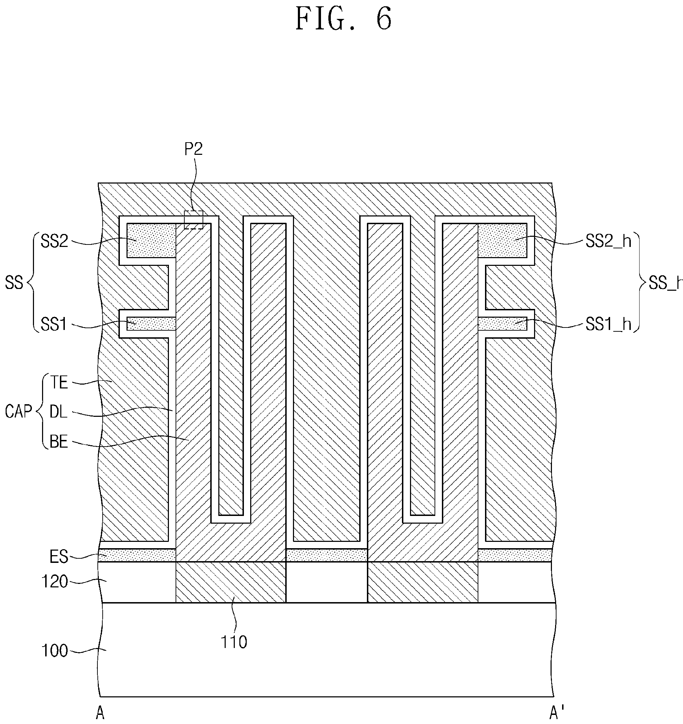

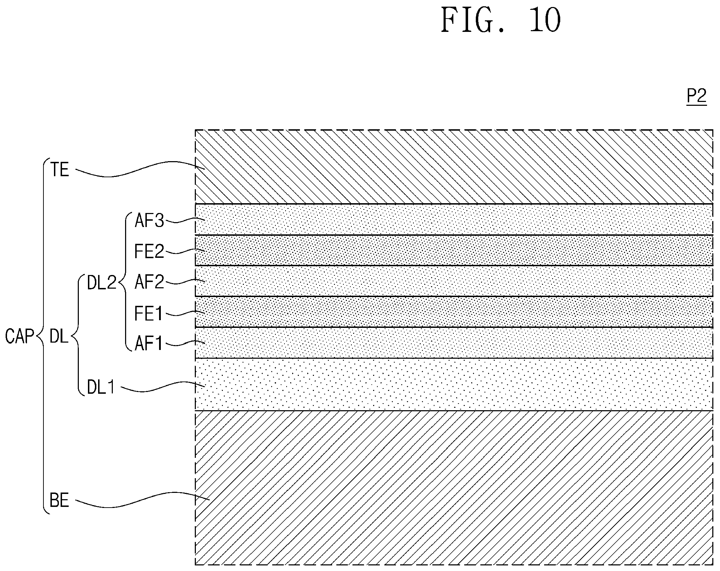

FIG. 6 illustrates a cross-sectional view taken along line A-A' of FIG. 2. FIG. 10 illustrates an enlarged view showing section P2 of FIGS. 6, 7, 8, and 9.

Referring to FIGS. 6 and 10, in a semiconductor device according to the present implementation, the bottom electrodes BE may each have a hollow cup shape or a cylindrical shape. Each of the bottom electrodes BE may have an inner lateral surface and an outer lateral surface. The first support pattern SS1 and the second support pattern SS2 may be disposed on the outer lateral surface of the bottom electrode BE. The dielectric layer DL may extend onto the inner lateral surface of each of the bottom electrodes BE. The top electrode TE may extend onto the top surfaces of the bottom electrodes BE. Other configurations may be identical to or similar to those discussed with reference to FIGS. 1 to 4B.

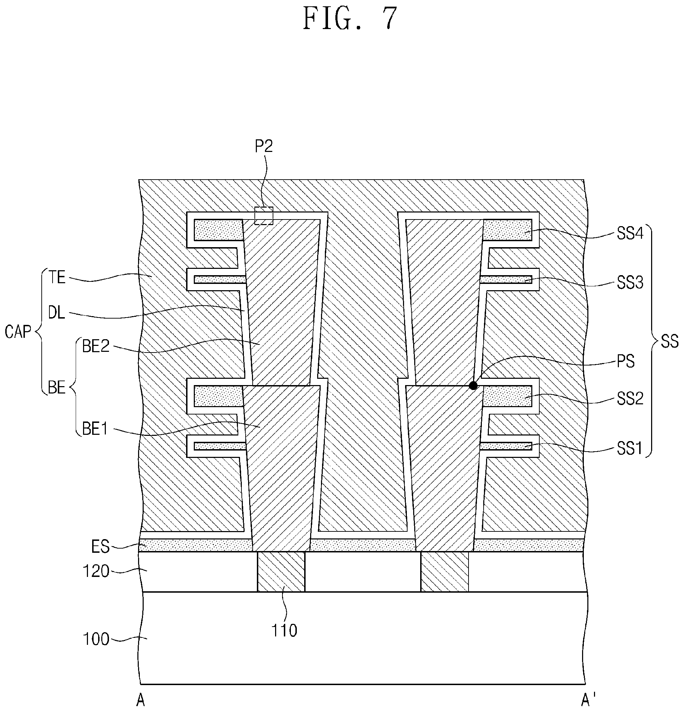

FIG. 7 illustrates a cross-sectional view taken along line A-A' of FIG. 2.

Referring to FIGS. 7 and 10, each of the bottom electrodes BE may include a lower pillar BE1 and an upper pillar BE2 disposed on the lower pillar BE1. A boundary may be present or absent between the lower pillar BE1 and the upper pillar BE2. The lower pillar BE1 and the upper pillar BE2 may each have an inclined sidewall. The bottom electrodes BE may each have an inflection point PS at its sidewall between the lower pillar BE1 and the upper pillar BE2. The lower pillar BE1 may have an upper portion wider than a lower portion of the upper pillar BE2.

The support pattern SS may include a first support pattern SS1, a second support pattern SS2, a third support pattern SS3, and a fourth support pattern SS4. The sidewall of the lower pillar BE1 may be in contact with the first and second support patterns SS1 and SS2 that are spaced apart from each other. The sidewall of the upper pillar BE2 may be in contact with the third and fourth support patterns SS3 and SS4 that are spaced apart from each other. The dielectric layer DL may extend to cover the first to fourth support patterns SS1 to SS4. Other configurations may be identical to or similar to those discussed with reference to FIGS. 1 to 4B.

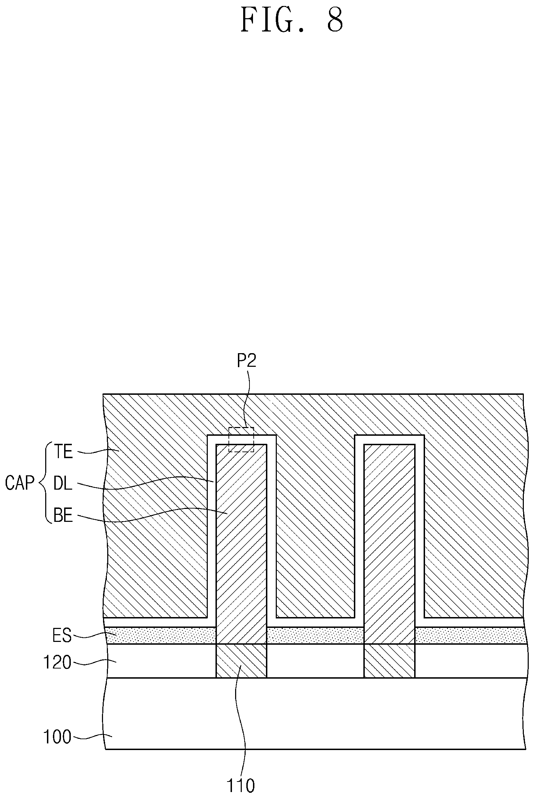

FIG. 8 illustrates a cross-sectional view showing an example semiconductor device.

Referring to FIGS. 8 and 10, the conductive contacts 110 and the interlayer dielectric layer 120 may be disposed on the first substrate 100. The etch stop layer ES may be disposed on the interlayer dielectric layer 120. The bottom electrodes BE may penetrate the etch stop layer ES to come into contact with corresponding conductive contacts 110. In the present implementations, the support patterns SS1 and SS2 of FIG. 3 may not be provided. Instead, the etch stop layer ES may serve to support the bottom electrodes BE. The dielectric layer DL may be formed on all lateral surfaces of the bottom electrodes BE. Other configurations may be identical to or similar to those discussed with reference to FIGS. 1 to 4B.

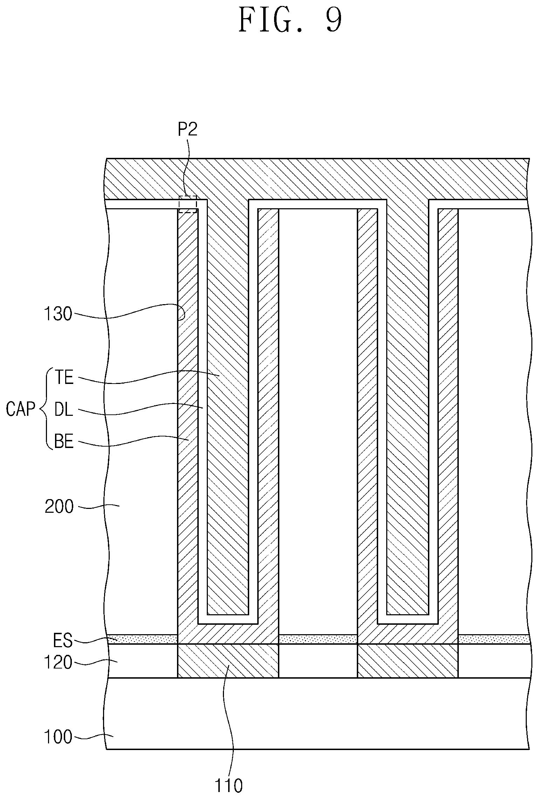

FIG. 9 illustrates a cross-sectional view showing an example semiconductor device.

Referring to FIGS. 9 and 10, the conductive contacts 110 and the interlayer dielectric layer 120 may be disposed on the first substrate 100. The etch stop layer ES may be disposed on the interlayer dielectric layer 120. A mold layer 200 may be disposed on the etch stop layer ES. The mold layer 200 may include lower electrode holes 130 that expose the conductive contacts 110. The bottom electrodes BE may be disposed in the lower electrode holes 130.

The bottom electrodes BE may each have a hollow cup shape or a cylindrical shape. Each of the bottom electrodes BE may have an inner lateral surface and an outer lateral surface. The outer lateral surfaces of the bottom electrodes BE may be in contact with the mold layer 200 and, optionally, in contact with the etch stop layer ES. The bottom electrodes BE may have their top surfaces coplanar with that of the mold layer 200. The dielectric layer DL may extend onto the top surface and the inner lateral surface of each of the bottom electrodes BE and the top surface of the mold layer 200. The dielectric layer DL may not cover the outer lateral surfaces of the bottom electrodes BE.

The top electrode TE may extend onto the inner lateral surface of each of the bottom electrodes BE. In the present implementations, the support patterns SS1 and SS2 of FIG. 3 may not be provided. Instead, the mold layer 200 may serve to support the bottom electrodes BE. Other configurations may be identical or similar to those discussed with reference to FIGS. 1 to 4B.

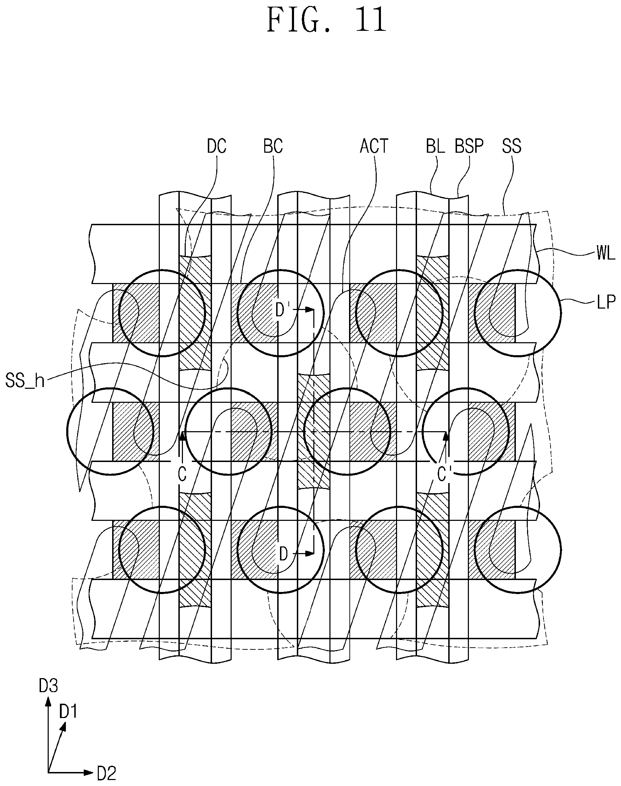

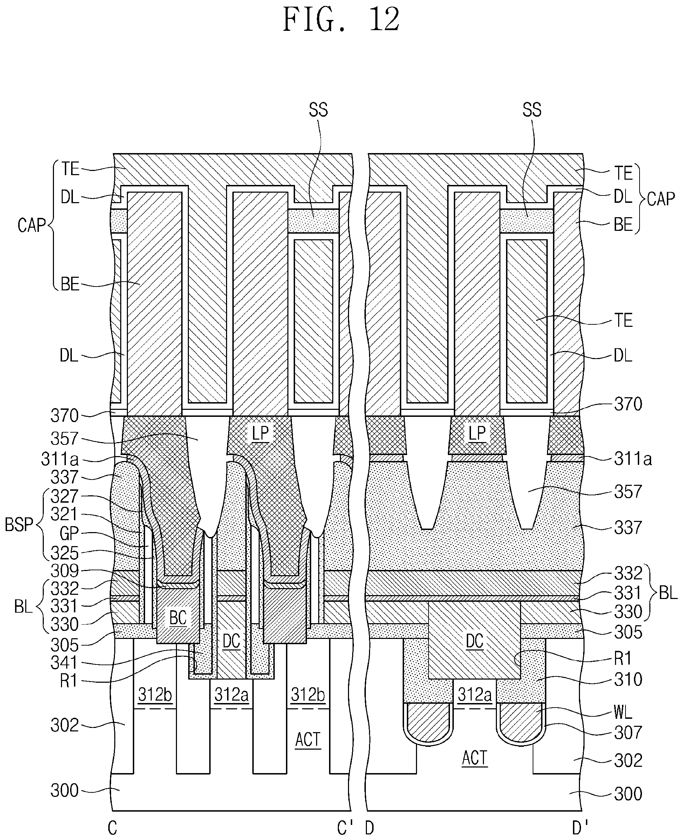

FIG. 11 illustrates a plan view showing an example semiconductor device. FIG. 12 illustrates a cross-sectional view taken along lines C-C' and D-D' of FIG. 11.

Referring to FIGS. 11 and 12, a second substrate 300 may be provided therein with device isolation patterns 302 that define active sections ACT. Each of the active sections ACT may have an isolated shape. Each of the active sections ACT may have a bar shape elongated along a first direction D1 in a plan view. When viewed in plan, the active sections ACT may correspond to portions of the second substrate 300 that are surrounded by the device isolation patterns 302. The second substrate 300 may include a semiconductor material. The active sections ACT may be arranged in parallel to each other such that one of the active sections ACT may have an end portion adjacent to a central portion of a neighboring one of the active sections ACT.

Word lines WL may run across the active sections ACT. The word lines WL may be disposed in grooves formed in the device isolation patterns 302 and the active sections ACT. The word lines WL may be parallel to a second direction D2 that intersects the first direction D1. The word lines WL may be formed of a conductive material. A gate dielectric layer 307 may be disposed between each of the word lines WL and an inner surface of each groove. Although not shown, the grooves may have their bottom surfaces located relatively deeper in the device isolation patterns 302 and relatively shallower in the active sections ACT. The gate dielectric layer 307 may include at least one material selected from thermal oxide, silicon nitride, silicon oxynitride, and high-k dielectrics. Each of the word lines WL may have a curved bottom surface. A high-k dielectric may be a material having a dielectric constant that is greater than that of silicon oxide.

A first doped region 312a may be disposed in the active section ACT between a pair of the word lines WL, and a pair of second doped regions 312b may be disposed in opposite edge portions of the active section ACT. The first and second doped regions 312a and 312b may be doped with, for example, N-type impurities. The first doped region 312a may correspond to a common drain region, and the second doped regions 312b may correspond to source regions. A transistor may be constituted by each of the word lines WL and its adjacent first and second doped regions 312a and 312b. As the word lines WL are disposed in the grooves, each of the word lines WL may have thereunder a channel region whose channel length becomes increased within a limited planar area. Accordingly, a short-channel effect may be minimized.

The word lines WL may have their top surfaces lower than those of the active sections ACT. A word-line capping pattern 310 may be disposed on the word line WL. The word-line capping patterns 310 may have linear shapes that extend along longitudinal directions of the word lines WL and may cover the entire top surfaces of the word lines WL. The grooves may have inner spaces not occupied by the word lines WL, and the word-line capping patterns 310 may fill the unoccupied inner spaces of the grooves. The word-line capping pattern 310 may be formed of, for example, a silicon nitride layer.

An interlayer dielectric pattern 305 may be disposed on the second substrate 300. The interlayer dielectric pattern 305 may be formed of a single layer or multiple layers including at least one selected from a silicon oxide layer, a silicon nitride layer, and a silicon oxynitride layer. The interlayer dielectric pattern 305 may be formed to have island shapes that are spaced apart from each other when viewed in plan. The interlayer dielectric pattern 305 may be formed to simultaneously cover end portions of two adjacent active sections ACT.

An upper portion of each of the second substrate 300, the device isolation pattern 302, and the word-line capping pattern 310 may be partially recessed to form a first recess R1. The first recess R1 may have a network shape when viewed in plan. The first recess R1 may have a sidewall aligned with that of the interlayer dielectric pattern 305.

Bit lines BL may be disposed on the interlayer dielectric pattern 305. The bit lines BL may run across the word-line capping patterns 310 and the word lines WL. As disclosed in FIG. 11, the bit lines BL may be in parallel to a third direction D3 that intersects the first and second directions D1 and D2. Each of the first, second and third directions, D1, D2 and D3 may be parallel to an upper surface of the second substrate 300. Each of the bit lines BL may include a bit-line polysilicon pattern 330, a bit-line ohmic pattern 331, and a bit-line metal-containing pattern 332 that are sequentially stacked. The bit-line polysilicon pattern 330 may include impurity-doped polysilicon or impurity-undoped polysilicon. The bit-line ohmic pattern 331 may include a metal silicide layer. The bit-line metal-containing pattern 332 may include at least one material selected from metal (e.g., tungsten, titanium, or tantalum) and conductive metal nitride (e.g., titanium nitride, tantalum nitride, or tungsten nitride). A bit-line capping pattern 337 may be disposed on each of the bit lines BL. The bit-line capping patterns 337 may be formed of a dielectric material such as a silicon nitride layer.

A bit-line contact DC may be disposed in the first recess R1 that intersects the bit line BL. The bit-line contact DC may include impurity-doped polysilicon or impurity-undoped polysilicon. When viewed in cross-section taken along line D-D' as illustrated in FIG. 12, the bit-line contact DC may have a sidewall in contact with a lateral surface of the interlayer dielectric pattern 305. When viewed in plan as shown in FIG. 11, the bit-line contact DC may have a concave lateral surface in contact with the interlayer dielectric pattern 305. The bit-line contact DC may electrically connect the first doped region 312a and the bit line BL to each other.

The first recess R1 may have an empty space not occupied by the bit-line contact DC, and a lower buried dielectric pattern 341 may occupy the empty space of the first recess R1. The lower buried dielectric pattern 341 may be formed of a single layer or multiple layers including at least one layer selected from a silicon oxide layer, a silicon nitride layer, and a silicon oxynitride layer.

Storage node contacts BC may be disposed between a pair of adjacent bit lines BL. The storage node contacts BC may be spaced apart from each other. The storage node contacts BC may include impurity-doped polysilicon or impurity-undoped polysilicon. The storage node contacts BC may have top surfaces which are concave upwards. A dielectric fence (not shown) may be disposed between the storage node contacts BC and between the bit lines BL.

A bit-line spacer BSP may be interposed between the bit line BL and the storage node contact BC. The bit-line spacer BSP may include a first sub-spacer 321 and a second sub-spacer 325 that are spaced apart from each other across a gap GP. The gap GP may be called an air gap. The first sub-spacer 321 may cover a sidewall of the bit line BL and a sidewall of the bit-line capping pattern 337. The second sub-spacer 325 may be adjacent to the storage node contact BC. The first sub-spacer 321 and the second sub-spacer 325 may include the same material. For example, the first sub-spacer 321 and the second sub-spacer 325 may include a silicon nitride layer.

The second sub-spacer 325 may have a bottom surface lower than that of the first sub-spacer 321. The second sub-spacer 325 may have a top end whose height is lower than that of a top end of the first sub-spacer 321. Such a configuration may increase a formation margin for landing pads LP which will be discussed below. As a result, connection may be ensured/improved between the landing pad LP and the storage node contact BC. The first sub-spacer 321 may extend to cover a sidewall of the bit-line contact DC and also to cover a sidewall and a bottom surface of the first recess R1. For example, the first sub-spacer 321 may be interposed between the bit-line contact DC and the lower buried dielectric pattern 341, between the interlayer dielectric layer 305 and the lower buried dielectric pattern 341, between the second substrate 300 and the lower buried dielectric pattern 341, and between the device isolation pattern 302 and the lower buried dielectric pattern 341.

A storage node ohmic layer 309 may be disposed on the storage node contact BC. The storage node ohmic layer 309 may include metal silicide. The storage node ohmic layer 309, the first and second sub-spacers 321 and 325, and the bit-line capping pattern 337 may be conformally covered with a diffusion break pattern 311a whose thickness is uniform. The diffusion break pattern 311a may include metal nitride, such as a titanium nitride layer or a tantalum nitride layer. A landing pad LP may be disposed on the diffusion break pattern 311a. The landing pad LP may correspond to the conductive contact 110 of FIG. 3. The landing pad LP may be formed of a material containing a metal such as tungsten. The landing pad LP may have an upper portion that covers a portion of a top surface of the bit-line capping pattern 337 and has a width greater than that of the storage node contact BC. A center of the landing pad LP may be shifted in a second direction D2 away from a center of the storage node contact BC. A portion of the bit line BL may vertically overlap the landing pad LP. An upper sidewall of the bit-line capping pattern 337 may overlap the landing pad LP and may be covered with a third sub-spacer 327. A pad separation pattern 357 may be interposed between the landing pads LP. The pad separation pattern 357 may correspond to the interlayer dielectric layer 120 of FIG. 3. The pad separation pattern 357 may include a silicon nitride layer, a silicon oxide layer, a silicon oxynitride layer, or a porous layer. The pad separation pattern 357 may define a top end of the gap GP. The third sub-spacer 327 may define a top end of the gap GP.

Bottom electrodes BE may be correspondingly disposed on the landing pads LP. A support pattern SS may connect portions of sidewalls of the bottom electrodes BE to each other. The support pattern SS may include a plurality of support holes SS_h.

An etch stop layer 370 may cover top surfaces of the pad separation pattern 357 between the bottom electrodes BE. The etch stop layer 370 may include a dielectric material, such as a silicon nitride layer, a silicon oxide layer, or a silicon oxynitride layer. A dielectric layer DL may cover surfaces of the bottom electrodes BE and a surface of the support pattern SS. The dielectric layer DL may be covered with a top electrode TE. The bottom electrode BE, the dielectric layer DL, and the top electrode TE may constitute a capacitor CAP. The capacitor CAP may correspond to the capacitor CAP of FIG. 1. Other configurations may be identical to or similar to those discussed with reference to FIGS. 1 to 4B.

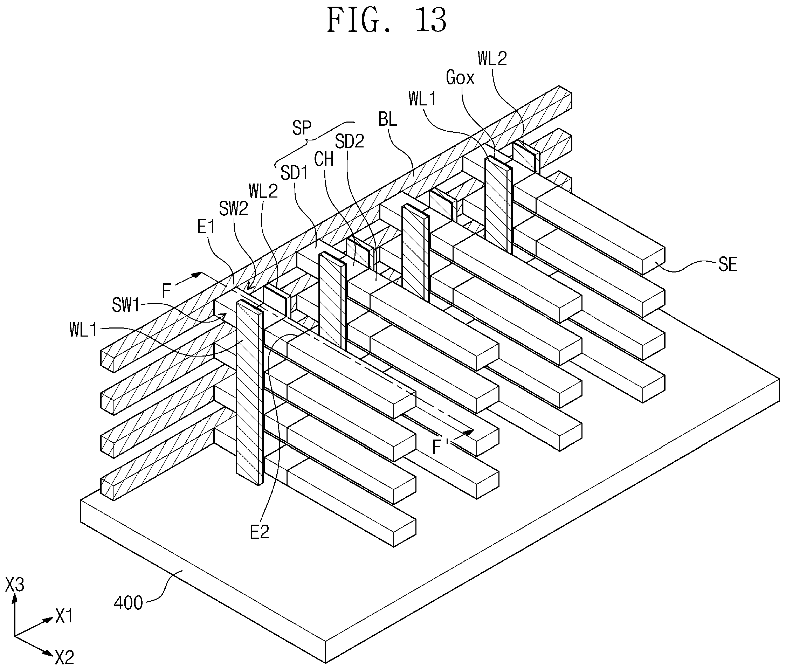

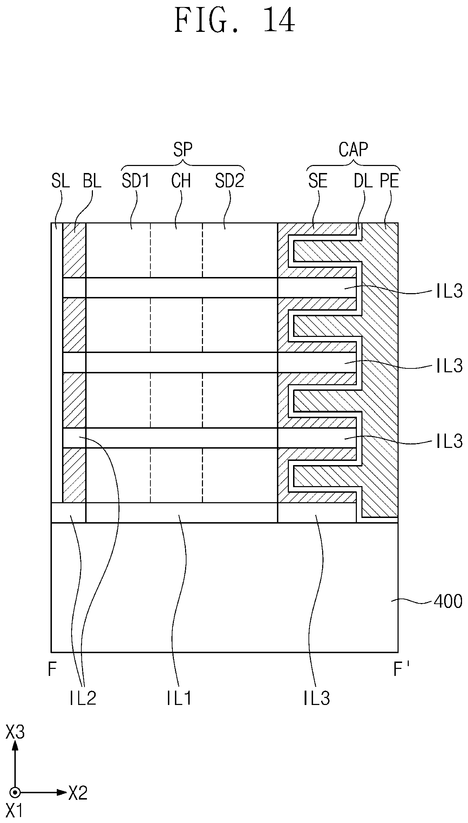

FIG. 13 illustrates a perspective view showing an example three-dimensional semiconductor memory device. FIG. 14 illustrates a cross-sectional view taken along line F-F' of FIG. 13.

Referring to FIGS. 13 and 14, a fourth substrate 400 may be provided thereon with semiconductor patterns SP that are spaced apart from each other in a first direction X1 and a third direction X3 that intersect each other. The semiconductor patterns SP may each have a bar shape elongated in a second direction X2 that intersects the first and third directions X1 and X3. The first and second directions X1 and X2 may be parallel to a top surface of the fourth substrate 400. The third direction X3 may be perpendicular to the top surface of the fourth substrate 400. The semiconductor patterns SP may each have a first end portion E1 and a second end portion E2 that are spaced apart from each other. In addition, the semiconductor patterns SP may each have a first lateral surface SW1 and a second lateral surface SW2 that connect the first and second end portions E1 and E2 to each other and are spaced apart from each other. The semiconductor patterns SP may include at least one material selected from silicon and germanium. The semiconductor patterns SP may each include a first source/drain region SD1 adjacent to the first end portion E1, a second source/drain region SD2 adjacent to the second end portion E2, and a channel region CH interposed between the first source/drain region SD1 and the second source/drain region SD2. The first source/drain region SD1 and the second source/drain region SD2 may each be an impurity region doped in the semiconductor pattern SP. The channel region CH may also be doped with impurities. For example, the first and second source/drain regions SD1 and SD2 may be doped with impurities having a first conductivity type, and the channel region CH may be doped with impurities having a second conductivity type opposite to the first conductivity type.

The fourth substrate 400 may be provided thereon with bit lines BL that are stacked and spaced apart from each other in the third direction X3. The bit lines BL may extend in the first direction X1. The first end portions E1 of the semiconductor patterns SP located at the same height may be connected to one bit line BL.

A first electrode SE may be connected to the second end portion E2 of the semiconductor pattern SP. The first electrode SE may correspond to the bottom electrode BE of FIG. 1. The first electrode SE may have a hollow cup or cylindrical shape that lies on its side.

First word lines WL1 may be adjacent to the first lateral surfaces SW1 of the semiconductor patterns SP. Second word lines WL2 may be adjacent to the second lateral surfaces SW2 of the semiconductor patterns SP. The first and second word lines WL1 and WL2 may extend in the third direction X3 from the top surface of the fourth substrate 400. One first word line WL1 and one second word line WL2 may be spaced apart from each other across the channel region CH of one semiconductor pattern SP. A gate dielectric layer Gox may be interposed between the semiconductor patterns SP and the first and second word lines WL1 and WL2. The gate dielectric layer Gox may include a high-k dielectric layer, a silicon oxide layer, a silicon nitride layer, a silicon oxynitride layer, or a combination thereof. For example, the high-k dielectric layer may include at least one material selected from hafnium oxide, hafnium silicon oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and lead zinc niobate.

The bit lines BL and the first and second word lines WL1 and WL2 may each include a conductive material. For example, the conductive material may include one of a doped semiconductor material (doped silicon, doped germanium, etc.), a conductive metal nitride material (titanium nitride, tantalum nitride, etc.), a metallic material (tungsten, titanium, tantalum, etc.), and a metal-semiconductor compound (tungsten silicide, cobalt silicide, titanium silicide, etc.).

The bit lines BL may extend in the first direction X1. The bit lines BL may be in contact with a separation dielectric pattern SL. When viewed in plan, the separation dielectric pattern SL may have a linear shape that extends in the first direction X1.

The first word lines WL1 may serve as gates that substantially dominate charge movement of the channel regions CH. The second word lines WL2 may serve as back gates that assist charge movement of the channel regions CH. A first interlayer dielectric layer IL1 may be interposed between the semiconductor patterns SP. A second interlayer dielectric layer IL2 may be interposed between the bit lines BL. A third interlayer dielectric layer IL3 may be interposed between the first electrodes SE. The third interlayer dielectric layer IL3 may serve to support the first electrodes SE. The separation dielectric pattern SL may be in contact with lateral surfaces of the bit lines BL and lateral surfaces of the second interlayer dielectric layers IL2. The first, second, and third interlayer dielectric layers IL1, IL2, and IL3 and the separation dielectric pattern SL may each be formed of a single layer or of multiple layers including at least one layer selected from a silicon oxide layer, a silicon oxynitride layer, and a silicon nitride layer.

The first electrode SE may be in contact with the third interlayer dielectric layer IL3. The first electrode SE may be in contact with the dielectric layer DL. The dielectric layer DL may be in contact with a second electrode PE. The first electrode SE, the dielectric layer DL, and the second electrode PE may constitute a capacitor CAP. The capacitor CAP may correspond to the capacitor CAP of FIG. 1. Other configurations may be identical to or similar to those discussed with reference to FIGS. 1 to 4B.

In a semiconductor device, antiferroelectric layers included in a capacitor may be doped with a group II element or a group III element (e.g., Al, Mg, or Be) to improve the crystallinity of the ferroelectric layers in contact with the antiferroelectric layers. The antiferroelectric layers may include a tetragonal crystal phase, and the ferroelectric layers may include an orthorhombic crystal phase. A morphotropic phase boundary (MPB) may thus be formed between the antiferroelectric layers and the ferroelectric layers, and accordingly the capacitor may have improved piezoelectric properties. In conclusion, a semiconductor device may have increased capacitance and decreased leakage current.

It is to be understood that when an element or layer is referred to as being "over", "above", "on", "below", "under", "beneath", "connected to" or "coupled to" another element or layer, it can be directly over, above, on, below, under, beneath, connected or coupled to the other element or layer or intervening elements or layers may be present. In contrast, when an element is referred to as being "directly over", "directly above", "directly on", "directly below", "directly under", "directly beneath", "directly connected to" or "directly coupled to" another element or layer, there are no intervening elements or layers present. In addition, a "layer" as described herein may be a single layer, or may comprise a plurality of layers (e.g. a plurality of sub-layers).

The terms "upper", "middle", "lower" may refer to relative positions along a particular direction (e.g. a vertical direction). For instance, a vertical direction may be defined perpendicular to an upper surface of a substrate. Various directions (e.g. vertical direction, horizontal direction, etc.) may be defined relative to the structure of the devices described herein. It will be appreciated that these directions do not necessarily imply any particular orientation of the device in use. The terms "upper", "middle", "lower", etc. may be replaced with terms, such as "first", "second", third" to be used to describe relative positions of elements. The terms "first", "second", third" may be used to describe various elements but the elements are not limited by the terms and a "first element" may be referred to as a "second element". Alternatively or additionally, the terms "first", "second", "third", etc. may be used to distinguish components from each other and do not limit the present disclosure. For example, the terms "first", "second", "third", etc. may not necessarily involve an order or a numerical meaning of any form.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Although some implementations have been discussed with reference to accompanying figures, it will be understood that various changes in form and details may be made therein without departing from the scope of this disclosure. It will be apparent to those skilled in the art that various substitution, modifications, and changes may be thereto without departing from the scope of the present disclosure. The invention is defined by the claims.

## Claims

1. A semiconductor device comprising a capacitor (CAP),
wherein the capacitor includes:
a bottom electrode (BE);
a first sub-dielectric layer (DL1) on the bottom electrode;
a second sub-dielectric layer (DL2) on the first sub-dielectric layer; and
a top electrode (TE) on the second sub-dielectric layer,
wherein the second sub-dielectric layer includes:
a first antiferroelectric layer (AF1) on the first sub-dielectric layer;
a second antiferroelectric layer (AF2) above the first antiferroelectric layer; and
a first ferroelectric layer (FE1) between the first antiferroelectric layer and the
second antiferroelectric layer,
**characterised in that**
each of the first and second antiferroelectric layers includes zirconium oxide that is doped with a first element, and
wherein the first sub-dielectric layer includes zirconium oxide that is not doped with the first element.

2. The semiconductor device of claim 1, wherein the first ferroelectric layer includes hafnium oxide or hafnium-zirconium oxide.

3. The semiconductor device of claim 2, wherein a component ratio of hafnium included in the first ferroelectric layer to zirconium included in the first ferroelectric layer is in a range of about 10:0 to about 5:5.

4. The semiconductor device of any preceding claim, wherein each of the first sub-dielectric layer, the first antiferroelectric layer, the second antiferroelectric layer, and the first ferroelectric layer has a thickness of about 5 Å to about 15 Å.

5. The semiconductor device any preceding claim, wherein the first element doped into the first and second antiferroelectric layers includes at least one element selected from Al, Mg, Be, Y, La, Ca, C, Si, Ge, Sn, Pb, Gd, and Ti.

6. The semiconductor device of any preceding claim, wherein the first ferroelectric layer comprises a material other than the first element.

7. The semiconductor device of any preceding claim, wherein
the first sub-dielectric layer is in contact with the bottom electrode, and
the second antiferroelectric layer is in contact with the top electrode.

8. The semiconductor device of any preceding claim, further comprising a support pattern (SS) in contact with an upper lateral surface of the bottom electrode, wherein the first sub-dielectric layer covers the support pattern.

9. The semiconductor device of any preceding claim, wherein
the first and second antiferroelectric layers includes a tetragonal crystal phase, and
the first ferroelectric layer includes an orthorhombic crystal phase.

10. The semiconductor device of any preceding claim, wherein the bottom electrode has a pillar shape or a cylindrical shape.

## Patentansprüche

1. Halbleitervorrichtung, die einen Kondensator (CAP) umfasst,
wobei der Kondensator beinhaltet:
eine untere Elektrode (BE);
eine erste Subdielektrikumschicht (DL1) auf der unteren Elektrode;
eine zweite Subdielektrikumschicht (DL2) auf der ersten Subdielektrikumschicht; und
eine obere Elektrode (TE) auf der zweiten Subdielektrikumschicht,
wobei die zweite Subdielektrikumschicht beinhaltet:
eine erste antiferroelektrische Schicht (AF1) auf der ersten Subdielektrikumschicht;
eine zweite antiferroelektrische Schicht (AF2) über der ersten antiferroelektrischen Schicht; und
eine erste ferroelektrische Schicht (FE1) zwischen der ersten antiferroelektrischen Schicht und der zweiten antiferroelektrischen Schicht,
**dadurch gekennzeichnet, dass** jede der ersten und zweiten antiferroelektrischen Schichten Zirkoniumoxid beinhaltet, das mit einem ersten Element dotiert ist, und
wobei die erste Subdielektrikumschicht Zirkoniumoxid beinhaltet, das nicht mit dem ersten Element dotiert ist.

2. Halbleitervorrichtung nach Anspruch 1, wobei die erste ferroelektrische Schicht Hafniumoxid oder Hafnium-Zirkoniumoxid beinhaltet.

3. Halbleitervorrichtung nach Anspruch 2, wobei ein Komponentenverhältnis von Hafnium, das in der ersten ferroelektrischen Schicht beinhaltet ist, zu Zirkonium, das in der ersten ferroelektrischen Schicht beinhaltet ist, in einem Bereich von etwa 10:0 bis etwa 5:5 liegt.

4. Halbleitervorrichtung nach einem vorstehenden Anspruch, wobei die erste Subdielektrikumschicht, die erste antiferroelektrische Schicht, die zweite antiferroelektrische Schicht und die erste ferroelektrische Schicht jeweils eine Dicke von etwa 5 Å bis etwa 15 Å aufweisen.

5. Halbleitervorrichtung nach einem vorstehenden Anspruch, wobei das erste in die erste und zweite antiferroelektrische Schicht dotierte Element mindestens ein Element beinhaltet, ausgewählt aus Al, Mg, Be, Y, La, Ca, C, Si, Ge, Sn, Pb, Gd und Ti.

6. Halbleitervorrichtung nach einem vorstehenden Anspruch, wobei die erste ferroelektrische Schicht ein anderes Material als das erste Element umfasst.

7. Halbleitervorrichtung nach einem vorstehenden Anspruch, wobei:
die erste Subdielektrikumschicht mit der unteren Elektrode in Kontakt steht und
die zweite antiferroelektrische Schicht mit der oberen Elektrode in Kontakt steht.

8. Halbleitervorrichtung nach einem vorstehenden Anspruch, ferner umfassend ein Trägermuster (SS), das mit einer oberen Seitenfläche der unteren Elektrode in Kontakt steht,
wobei die erste Subdielektrikumschicht das Trägermuster bedeckt.

9. Halbleitervorrichtung nach einem vorstehenden Anspruch, wobei:
die erste und zweite antiferroelektrische Schicht eine tetragonale Kristallphase beinhalten und
die erste ferroelektrische Schicht eine orthorhombische Kristallphase beinhaltet.

10. Halbleitervorrichtung nach einem vorstehenden Anspruch, wobei die untere Elektrode eine Säulenform oder Zylinderform aufweist.

## Revendications

1. Dispositif semi-conducteur comprenant un condensateur (CAP),
dans lequel le condensateur inclut :
une électrode inférieure (BE) ;
une première sous-couche diélectrique (DL1) sur l'électrode inférieure ;
une seconde sous-couche diélectrique (DL2) sur la première sous-couche diélectrique ; et
une électrode supérieure (TE) sur la seconde sous-couche diélectrique,
dans lequel la seconde sous-couche diélectrique inclut :
une première couche antiferroélectrique (AF1) sur la première sous-couche diélectrique ;
une seconde couche antiferroélectrique (AF2) au-dessus de la première couche antiferroélectrique ; et
une première couche ferroélectrique (FE1) entre la première couche antiferroélectrique et la seconde couche antiferroélectrique,
**caractérisé en ce que** chacune des première et seconde couches antiferroélectriques inclut de l'oxyde de zirconium qui est dopé avec un premier élément, et
dans lequel la première sous-couche diélectrique inclut de l'oxyde de zirconium qui n'est pas dopé avec le premier élément.

2. Dispositif semi-conducteur selon la revendication 1, dans lequel la première couche ferroélectrique inclut de l'oxyde d'hafnium ou de l'oxyde d'hafnium et de zirconium.

3. Dispositif semi-conducteur selon la revendication 2, dans lequel un rapport de composant entre l'hafnium inclus dans la première couche ferroélectrique et le zirconium inclus dans la première couche ferroélectrique est dans une plage d'environ 10:0 à environ 5:5.

4. Dispositif semi-conducteur selon une quelconque revendication précédente, dans lequel chacune de la première couche sous-diélectrique, de la première couche antiferroélectrique, de la seconde couche antiferroélectrique et de la première couche ferroélectrique présente une épaisseur d'environ 5 Å à environ 15 Å.

5. Dispositif semi-conducteur selon une quelconque revendication précédente, dans lequel le premier élément dopé dans les première et seconde couches antiferroélectriques inclut au moins un élément choisi parmi Al, Mg, Be, Y, La, Ca, C, Si, Ge, Sn, Pb, Gd et Ti.

6. Dispositif semi-conducteur selon une quelconque revendication précédente, dans lequel la première couche ferroélectrique comprend un matériau autre que le premier élément.

7. Dispositif semi-conducteur selon une quelconque revendication précédente, dans lequel
la première sous-couche diélectrique est en contact avec l'électrode inférieure, et
la seconde couche antiferroélectrique est en contact avec l'électrode supérieure.

8. Dispositif semi-conducteur selon une quelconque revendication précédente, comprenant en outre un motif de support (SS) en contact avec une surface latérale supérieure de l'électrode inférieure,
dans lequel la première sous-couche diélectrique recouvre le motif de support.

9. Dispositif semi-conducteur selon une quelconque revendication précédente, dans lequel
les première et seconde couches antiferroélectriques incluent une phase cristalline tétragonale, et
la première couche ferroélectrique inclut une phase cristalline orthorhombique.

10. Dispositif semi-conducteur selon une quelconque revendication précédente, dans lequel l'électrode inférieure présente une forme de pilier ou une forme cylindrique.
